# EUROPÄISCHE PATENTANMELDUNG

(11) **EP 4 570 966 A1**
(43) Veröffentlichungstag der Anmeldung: **18.06.2025**
(21) Anmeldenummer: 23216149.7
(22) Anmeldetag: 13.12.2023
(51) Int. Cl.: C30B 13/20, C30B 29/06

(54) **FLOAT-ZONE-VORRICHTUNG MIT VERSTELLBAREM KONDENSATOR**

(71) Anmelder: Siltronic AG, 81677 München (DE)
(72) Erfinder: Brenninger, Georg, 84564 Oberbergkirchen (DE)
(74) Vertreter: Hasenhütl, Eva

(57) **Zusammenfassung**

Die Erfindung betrifft eine Float-Zone-Vorrichtung, die dazu ausgebildet ist, während eines Float-Zone-Prozesses aus einem Polykristallstab über sukzessives, zonenweises Aufschmelzen entlang der Höhenrichtung des Polykristallstabs durch induktive Erwärmung mittels der kontinuierlichen Einbringung thermischer Leistung über eine sich entlang der Höhenrichtung des Polykristallstabs bewegende, und den Polykristallstab beabstandet umgebende, Spuleneinheit (5) der Float-Zone-Vorrichtung, den Einkristallstab herzustellen, wobei eine aktuelle thermische Leistung während des Float-Zone-Prozesses aus einer aktuellen Wirkleistung einer Sendereinheit (4), umfassend einen Kondensator (1), der Float-Zone-Vorrichtung stammt, die mit der Spuleneinheit (5) elektrisch zusammenwirkt. Der Kondensator (3) ist verstellbar und ist dazu ausgebildet, die Frequenz der Sendereinheit (4) während des Float-Zone-Prozesses auf einem vorgebbaren und im Wesentlichen konstanten Wert eingestellt zu halten.

## Beschreibung

### Technisches Gebiet

Die Erfindung betrifft eine Float-Zone Vorrichtung und ein Verfahren zur Herstellung eines Einkristallstabs, insbesondere aus Silizium, aus einem Polykristallstab, insbesondere aus Silizium, mittels Float-Zone-Prozess an der Float-Zone-Vorrichtung.

### Stand der Technik und technische Aufgabe

Beim Float-Zone-Prozess zur Herstellung eines Einkristallstabs aus Silizium zeigt sich, dass sich die Frequenz der Sendereinheit stark abhängig von der Last verändert.

Es zeigt sich bei gattungsgemäßen Float-Zone-Prozessen, dass beim Tropfenmachen die Last vergleichsweise gering ist und es stellt sich folglich eine deutlich niedrigere Frequenz in der Sendereinheit ein als beispielsweise dann gegen Ende des herzustellenden Einstristallstabs bei maximaler Last. Dieser Frequenzgang zwischen dem Ansetzen (Tropfen machen bis Konus) und der Phase des fertig hergestellten Einkristallstabs beträgt üblicherweise ca. 150 bis 200 kHz.

Bei Sendereinheiten hat sich weiterhin in diesem Zusammenhang gezeigt, dass sich bedingt durch das Zusammenwirken von Spulen und Kondensatoren für die Frequenzerzeugung ein sogenanntes "Leistungsloch" einstellen kann. Ein derartiges Leistungsloch hat die negative Auswirkung, dass die Verlustleistung, die die Sendereinheit immer erzeugt, in diesem Frequenzbereich extrem ausgeprägt ist. Beispielsweise kann bei einer vorgebbaren Bestückung einer Sendereinheit für eine Float-Zone-Vorrichtung ein Leistungsloch in einem Frequenzbereich von 2800 bis 3000 kHz auftreten.

Die Problematik für die Einkristallstabherstellung mittels Float-Zone-Prozess besteht nun darin, dass während des Float-Zone-Prozesses in diesem Leistungsloch viel zu wenig Wirkleistung als thermische Leistung bei dem Einkristallstab ankommt und es somit zu unvorhersehbaren Auswirkungen am Einkristallstab (z.B. Einfrieren, Abtropfen, Versetzungen, etc.) kommen kann.

Der vorliegenden Erfindung liegt daher die objektive, technische Aufgabe zu Grunde, auf einfache Weise eine Float-Zone-Vorrichtung und ein Verfahren zur Herstellung eines Einkristallstabs mittels Float-Zone-Prozess bereitzustellen, welche die oben genannten Nachteile nicht oder zumindest in geringerem Ausmaß aufweisen und welche insbesondere einen lastbedingten Frequenzgang, welcher beispielsweise im Bereich von 150 bis 200 kHz liegen kann, während des Float-Zone-Prozesses zu vermeiden.

Gelöst wird die Aufgabe durch eine Float-Zone-Vorrichtung nach Anspruch 1, sowie durch ein Verfahren zur Herstellung eines Einkristallstabs mittels Float-Zone-Prozess gemäß den Merkmalen nach Anspruch 7.

### Beschreibung der Erfindung

Die Erfindung hat erkannt, dass bei der bekannten Forderung, wonach man bei der Erzeugung eines Float-Zone-Einkristallstabs vom Start des Float-Zone-Prozesses mit Aufheizen des Kristallstabs bis zum Ende der Herstellung des Einkristallstabs einen möglichst vorhersehbaren und reproduzierbaren effektiven Leistungseintrag in den Kristallstab anstrebt, sich dementsprechend auch die von der Sendereinheit in diesem Frequenzbereich zur Verfügung gestellte Leistung so verhalten muss.

Hierbei liegt der Erfindung die technische Lehre zugrunde, dass man auf einfache Weise eine im Wesentlichen konstante Wirkleistung über die Sendereinheit in Form einer thermischen Leistung zonenweise über die Spuleneinheit in den Polykristallstab einbringen kann (zur Herstellung eines Einkristallstabs mit im Wesentlichen einheitlichen Materialeigenschaften), wenn die Float-Zone-Vorrichtung bzw. der Float-Zone-Prozess derart ausgebildet ist, dass die Frequenz der Sendereinheit während des gesamten Float-Zone-Prozesses auf einem vorgebbaren und im Wesentlichen konstanten Wert eingestellt gehalten wird (indem kontinuierlich über den Float-Zone-Prozess regulierend über eine Einstellung nachgeführt wird). Gelöst wird diese feste Einstellung der Frequenz, indem die Sendereinheit einen verstellbaren Kondensator umfasst.

Durch die beschriebene Anpassung der Frequenz mit Kondensator während des Float-Zone-Prozesses können die aus dem Stand der Technik bekannten oben beschriebenen Nachteile im vollem Umfang überwunden werden; insbesondere kann der nachteilige, lastbedingte Frequenzgang, welcher beispielsweise im Bereich von 150 bis 200 kHz liegen kann, und dessen negativen Auswirkungen auf den Prozess dadurch vermieden werden.

Gemäß einem ersten Aspekt betrifft die Erfindung daher eine Float-Zone-Vorrichtung, die dazu ausgebildet ist, während eines Float-Zone-Prozesses aus einem Polykristallstab, insbesondere aus Silizium, über sukzessives, zonenweises Aufschmelzen entlang der Höhenrichtung des Polykristallstabs durch induktive Erwärmung mittels der kontinuierlichen Einbringung thermischer Leistung über eine sich entlang der Höhenrichtung des Polykristallstabs bewegende, und den Polykristallstab beabstandet umgebende, Spuleneinheit der Float-Zone-Vorrichtung, den Einkristallstab herzustellen.

Eine aktuelle thermische Leistung während des Float-Zone-Prozesses stammt hierbei aus einer aktuellen Wirkleistung einer Sendereinheit, umfassend einen Kondensator, der Float-Zone-Vorrichtung, wobei die Sendereinheit mit der Spuleneinheit, insbesondere über eine Leistungsgeneratoreinheit, elektrisch zusammenwirkt.

Der Kondensator ist verstellbar ausgebildet und hierbei dazu ausgebildet, die Frequenz der Sendereinheit während des Float-Zone-Prozesses auf einem vorgebbaren und im Wesentlichen konstanten Wert eingestellt zu halten.

Hierdurch kann insbesondere die aus dem Stand der Technik bekannte Problematik vermieden werden, dass es zu Schwankungen der effektiven Leistung bzw. Wirkleistung kommt.

Mit dem verstellbaren Kondensator kann eine lastabhängige Frequenzverschiebung vermieden werden.

Bei bevorzugten Varianten kann der verstellbare Kondensator als verstellbarer Drehkondensator ausgebildet sein.

Bei bevorzugten Varianten kann der verstellbare Kondensator mittels eines Stellantriebes über eine Regelschleife betreibbar sein, wobei die Ansteuerung der Stellung des Kondensators über eine Motoreinheit erfolgen kann. Vorzugsweise stellt die Motoreinheit über die Ansteuerung der Stellung des Kondensators den vorgebbaren Wert der Frequenz, unabhängig von der Last, über den Float-Zone-Prozess kontinuierlich ein.

Bei weiteren bevorzugten Varianten kann der verstellbare Kondensator dazu ausgebildet sein, die einstellbare Frequenz während des Float-Zone-Ziehprozesses im Wesentlichen auf einem konstanten Wert zu halten, der in dem Bereich von 2600 kHz bis 3100 kHz liegen kann, vorzugsweise in dem Bereich von 2850 kHz bis 3000 kHz liegt, weiter vorzugsweise im Wesentlichen 2970 kHz, entspricht. Die Float-Zone-Vorrichtung gemäß der Erfindung ist allerdings nicht auf diese Werte der Frequenz beschränkt und auch bei einer Frequenz unterhalb oder oberhalb dieser Wertebereiche realisierbar.

Bei weiteren bevorzugten Varianten kann der Einkristallstab einen Anfangskonus, einen im Wesentlichen geformten Zylinderstababschnitt und einen Endkonus umfassen, wobei die Float-Zone-Vorrichtung dazu ausgebildet sein kann, über die Ansteuerung des verstellbaren Kondensators den vorgebbaren Wert der Frequenz für den Anfangskonus, den Zylinderstababschnitt und den Endkonus unabhängig voneinander einzustellen.

Bei weiteren bevorzugten Varianten kann der verstellbare Kondensator dazu ausgebildet sein, einen lastbedingten Frequenzgang, insbesondere in einem Bereich von 150 bis 200 kHz, während des Float-Zone-Prozesses zur Herstellung eines Einkristallstabs aus einem Polykristallstab, zu vermeiden.

Insbesondere ist die Spuleneinheit als Hochleistungsinduktionsspule ausgebildet.

Was den grundsätzlichen Vorgang der Aufschmelzung an dem Polykristallstab angeht, geschieht dies bei der erfindungsgemäßen Vorrichtung und bei dem erfindungsgemäßen Verfahren auf bekannte Weise, sodass auf diesen Aspekt hier nicht näher eingegangen wird.

Durch das Vorsehen des erfindungsgemäßen verstellbaren Kondensators (oder in Kombination mit einer oder mehrerer ihrer bevorzugten Varianten) an der Float-Zone-Vorrichtung und für das erfindungsgemäße Verfahren (oder in Kombination mit einer oder mehrerer ihrer bevorzugten Varianten), welches den verstellbaren Kondensator verwendet, ergeben sich u.a. folgende Vorteile für den herzustellenden Einkristallstab:
> Möglichkeit den Prozess wieder im optimalen Frequenzbereich für das Aufschmelzen vom Polykristallstab und der Herstellung eines Einkristallstabs von ca. 3000 kHz zu betreiben.
> Vermeidung vom Durchfahren des Leistungsloches und dadurch Prozessstabilität während des Float-Zone-Prozesses. Dadurch wird u.a. das Einfahren der Float-Zone-Vorrichtungskomponenten, insbesondere der Hochfrequenzinduktionsspule, wesentlich erleichtert.
> Möglichkeit, optimale Frequenzeinstellungen in verschiedenen Prozessphasen während des Float-Zone-Prozesses einzustellen, wodurch sich eine Erhöhung der Ausbeute ergibt.
> Beeinflussung der Schmelzebewegung und dadurch auch Reduzierung von Versetzungen innerhalb des herzustellenden Einkristallstabs; weiterhin vorzugsweise auch Optimierung des radialen Widerstands (beschrieben in Form der Radialen-Widerstands-Variation RRV) während des Float-Zone-Prozesses infolge ständiger Änderung bzw. Anpassung der Einstellung der Frequenz in der Stabphase.

Gemäß einem zweiten Aspekt betrifft die Erfindung daher ein Verfahren zur Herstellung eines Einkristallstabs, insbesondere aus Silizium, aus einem Polykristallstab, insbesondere aus Silizium, mittels Float-Zone-Prozess an der erfindungsgemäßen Float-Zone-Vorrichtung oder (in Kombination mit einer ihrer bevorzugten Varianten wie oben beschrieben), wobei
- während des Float-Zone-Prozesses aus dem Polykristallstab über sukzessives, zonenweises Aufschmelzen entlang der Höhenrichtung des Polykristallstabs durch induktive Erwärmung mittels der kontinuierlichen Einbringung thermischer Leistung über eine sich entlang der Höhenrichtung des Polykristallstabs bewegende, und den Polykristallstab beabstandet umgebende, Spuleneinheit der Float-Zone-Vorrichtung, der Einkristallstab hergestellt wird, wobei eine aktuelle thermische Leistung während des Float-Zone-Prozesses aus einer aktuellen Wirkleistung einer Sendereinheit, umfassend einen Kondensator, der Float-Zone-Vorrichtung stammt, die mit der Spuleneinheit, insbesondere über eine Leistungsgeneratoreinheit, elektrisch zusammenwirkt, und wobei
- während des Float-Zone-Prozesses der Kondensator, der verstellbar ausgeführt ist, die Frequenz der Sendereinheit auf einem vorgebbaren und im Wesentlichen konstanten Wert über den Float-Zone-Prozess einstellbar hält.

Bei bevorzugten Varianten kann der verstellbare Kondensator mittels eines Stellantriebes über eine Regelschleife betrieben werden, wobei die Ansteuerung der Stellung des Kondensators über eine Motoreinheit erfolgen kann.

Bei bevorzugten Varianten kann der verstellbare Kondensator als verstellbarer Drehkondensator ausgebildet sein.

Bei weiteren bevorzugten Varianten kann die Motoreinheit über die Ansteuerung der Stellung des Kondensators den vorgebbaren Wert der Frequenz, unabhängig von der Last, über den Float-Zone-Prozess kontinuierlich einstellen.

Bei weiteren bevorzugten Varianten kann der Einkristallstab einen Anfangskonus, einen im Wesentlichen geformten Zylinderstababschnitt und einen Endkonus umfassen, wobei der vorgebbare Wert der Frequenz über die Ansteuerung des verstellbaren Kondensators für den Anfangskonus, den Zylinderstababschnitt und den Endkonus unabhängig voneinander eingestellt werden kann.

Bei weiteren bevorzugten Varianten kann der vorgebbare Wert der Frequenz in dem Bereich von 2600 kHz bis 3100 kHz liegen, vorzugsweise in dem Bereich von 2850 kHz bis 3000 kHz liegen, weiter vorzugsweise im Wesentlichen 2970 kHz, entsprechen. Das Verfahren gemäß der Erfindung ist allerdings nicht auf diese Werte der Frequenz beschränkt und auch bei einer Frequenz unterhalb oder oberhalb der Wertebereiche realisierbar.

Bevorzugt ist der Kondensator in dem Primärkreis des Transformators der Sendereinheit angeordnet. Bei alternativen Varianten kann er auch in dem Sekundärkreis des Transformators der Sendereinheit angeordnet werden.

Weiterhin betrifft die Erfindung ein Verfahren zur Herstellung einer Scheibe aus Halbleitermaterial aus einem Einkristallstab, insbesondere aus einem Silizium, welcher mit dem erfindungsgemäßen Verfahren zur Herstellung eines Einkristallstabs, insbesondere aus Silizium, mittels Float-Zone-Prozess (oder in Kombination mit einem oder mehreren seiner bevorzugten Varianten) an der erfindungsgemäßen Float-Zone-Vorrichtung (oder in Kombination mit einer oder mehrerer ihrer vorteilhaften Varianten) hergestellt wurde, wobei ausgehend von dem Ende des Verfahrens zur Herstellung des Einkristallstabs wenigstens folgende Schritte folgen:
- Sägen des Einkristallstabs in dünne Scheiben,
- Chemische und/oder mechanische Weiterbehandlung wenigstens einer der dünnen Scheiben aus Halbmaterial, wobei die Weiterbehandlung wenigstens einen Weiterbehandlungsschritt aus Kantenverrunden, Läppen, Reinigen, Polieren, Abscheiden einer Oxidschicht, epitaktisches Wachsen einer einkristallinen Schicht, insbesondere Siliziumschicht, oder einer SiGe Schicht oder einer GaN Schicht, umfasst.

### Kurzbeschreibung der Figur

**Figur 1** zeigt eine schematische Darstellung eines Ausschnittes der Float-Zone-Vorrichtung, umfassend die Sendereinheit 4 mit dem erfindungsgemäßen verstellbaren Kondensator 1, die Spuleneinheit 5 und den Kristallstab während des Float-Zone-Prozesses (angedeutet innerhalb der Spuleneinheit 5 und beabstandet dazu verlaufend).
**Figur 2** zeigt einen Ausschnitt des elektrischen Ersatzschaltbilds der Sendereinheit 4 im Übergangsbereich (rechte, offene Seite im Ersatzschaltbild) zur Spuleneinheit 5 mit dem erfindungsgemäßen, verstellbaren Kondensator 1.

### Detaillierte Beschreibung eines bevorzugten Ausführungsbeispiels

Im Folgenden wird ein bevorzugtes Ausführungsbeispiel der erfindungsgemäßen Float-Zone-Vorrichtung beschrieben, die zur Durchführung des erfindungsgemäßen Verfahrens zur Herstellung eines Einkristallstabs aus Silizium ausgebildet ist.

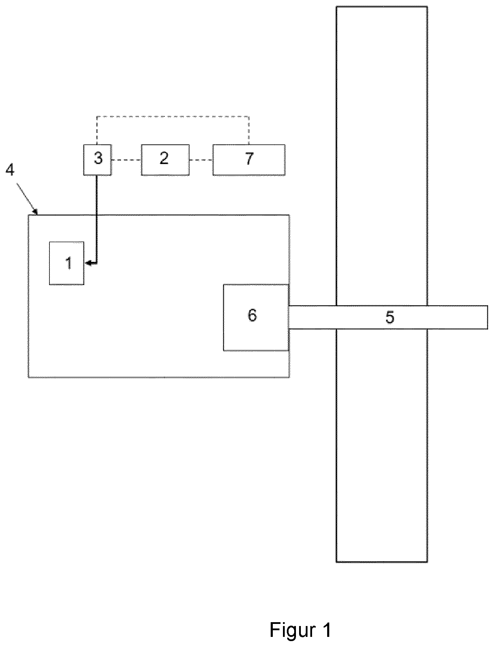

Während eines Float-Zone-Prozesses wird an der Float-Zone-Vorrichtung aus einem Polykristallstab (angedeutet in Figur 1) über sukzessives, zonenweises Aufschmelzen entlang der Höhenrichtung des Polykristallstabs durch induktive Erwärmung mittels der kontinuierlichen Einbringung thermischer Leistung über eine sich entlang der Höhenrichtung des Polykristallstabs bewegende, und den Polykristallstab beabstandet umgebende, Spuleneinheit 5 der Float-Zone-Vorrichtung, ein Einkristallstab aus Silizium hergestellt.

Eine aktuelle thermische Leistung während des Float-Zone-Prozesses stammt hierbei aus einer aktuellen Wirkleistung einer Sendereinheit 4 der Float-Zone-Vorrichtung, umfassend einen Kondensator 1, wobei die Sendereinheit 4 mit der Spuleneinheit 5 über eine Leistungsgeneratoreinheit 6 elektrisch zusammenwirkt.

Der Kondensator 1 ist verstellbar und dazu ausgebildet, die Frequenz der Sendereinheit 5 während des Float-Zone-Prozesses auf einem vorgebbaren und im Wesentlichen konstanten Wert eingestellt, unabhängig von der Last, zu halten.

Der verstellbare Kondensator 1 ist als verstellbarer Drehkondensator ausgebildet.

Der verstellbare Kondensator 1 ist hierbei mittels eines Stellantriebes über eine Regelschleife betreibbar. Die Ansteuerung der Stellung des Kondensators 1 erfolgt über eine Motoreinheit 3, wie in Figur 1 höchst schematisch angedeutet. Die Motoreinheit 3 stellt hierbei über die Ansteuerung der Stellung des Kondensators 1 den vorgebbaren Wert der Frequenz, unabhängig von der Last, über den Float-Zone-Prozess kontinuierlich ein. Die Motoreinheit 3 wiederum wird über eine Steuereinheit 7 angesteuert, wobei eine Frequenzüberprüfeinheit 2 zwischengeschaltet ist.

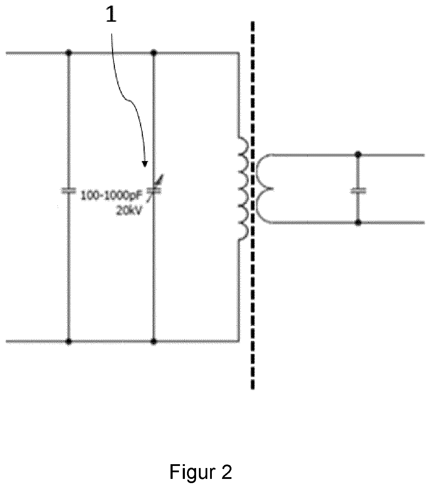

Figur 2 zeigt einen Ausschnitt des elektrischen Ersatzschaltbilds der Sendereinheit 4 im Übergangsbereich (rechte, offene Seite im Ersatzschaltbild in Figur 2) zur Spuleneinheit 5 mit dem erfindungsgemäßen, verstellbaren Kondensator 1, markiert in Figur 2. Der Übergang vom Primärkreis in den Sekundärkreis ist durch die gestrichelte Linie angedeutet, welche einen Transformator darstellt. Der Kondensator 1 liegt im vorliegenden Ausführungsbeispiel innerhalb des Primärkreises und weist eine einstellbare, veränderbare Kapazität im Bereich von 100 bis 1000 pF bei einer Spannung von 20 kV auf. Bei anderen bevorzugten Varianten der Erfindung sind jedoch auch andere Einstellungen in anderen Kapazitätswertebereichen und anderen Spannungsbereichen möglich und die Erfindung ist nicht auf diese Werte für den verstellbaren Kondensator beschränkt.

Der verstellbare Kondensator 1 ist hierbei dazu ausgebildet, die einstellbare Frequenz während des Float-Zone-Ziehprozesses im Wesentlichen auf einem konstanten Wert zu halten, der im Wesentlichen 2970 kHz entspricht, und damit im Gegensatz zu bekannten Ausführungen von Float-Zone-Vorrichtungen dazu ausgebildet, einen lastbedingten Frequenzgang, insbesondere in einem Bereich von 150 bis 200 kHz, während des Float-Zone-Prozesses zur Herstellung eines Einkristallstabs aus einem Polykristallstab, zu vermeiden (mit anderen Worten ist bei erfindungsgemäßer Ausführung der Frequenzgang theoretisch gegen 0, bedingt durch das Regelverhalten mit einer Schwankung von üblicherweise ca. +/- 2kHz).

Nach Herstellung des Einkristallstabs aus Silizium werden aus dem Einkristallstab Scheiben aus Halbleitermaterial hergestellt, wobei folgende Schritte folgen:
- Sägen des Einkristallstabs in dünne Scheiben,
- Chemische und mechanische Weiterbehandlung der dünnen Scheiben aus Halbmaterial, wobei die Weiterbehandlung die Weiterbehandlungsschritte Kantenverrunden, Läppen, Reinigen, Polieren umfasst.

## Patentansprüche

1. Float-Zone-Vorrichtung, die dazu ausgebildet ist, während eines Float-Zone-Prozesses aus einem Polykristallstab über sukzessives, zonenweises Aufschmelzen entlang der Höhenrichtung des Polykristallstabs durch induktive Erwärmung mittels der kontinuierlichen Einbringung thermischer Leistung über eine sich entlang der Höhenrichtung des Polykristallstabs bewegende, und den Polykristallstab beabstandet umgebende, Spuleneinheit (5) der Float-Zone-Vorrichtung, den Einkristallstab herzustellen, wobei eine aktuelle thermische Leistung während des Float-Zone-Prozesses aus einer aktuellen Wirkleistung einer Sendereinheit (4), umfassend einen Kondensator (1), der Float-Zone-Vorrichtung stammt, die mit der Spuleneinheit (5), insbesondere über eine Leistungsgeneratoreinheit, elektrisch zusammenwirkt,
**dadurch gekennzeichnet, dass**
der Kondensator (1) verstellbar ist und dazu ausgebildet ist, die Frequenz der Sendereinheit (4) während des Float-Zone-Prozesses auf einem vorgebbaren und im Wesentlichen konstanten Wert eingestellt, insbesondere unabhängig von der Last, zu halten.

2. Float-Zone-Vorrichtung nach Anspruch 1, wobei der verstellbare Kondensator (1) mittels eines Stellantriebes über eine Regelschleife betreibbar ist, wobei die Ansteuerung der Stellung des Kondensators (1) über eine Motoreinheit (3) erfolgt.

3. Float-Zone-Vorrichtung nach Anspruch 2, wobei die Motoreinheit (3) über die Ansteuerung der Stellung des Kondensators den vorgebbaren Wert der Frequenz, unabhängig von der Last, über den Float-Zone-Prozess kontinuierlich einstellt.

4. Float-Zone-Vorrichtung nach einem der Ansprüche 1 bis 3, wobei der Einkristallstab einen Anfangskonus, einen im Wesentlichen geformten Zylinderstababschnitt und einen Endkonus umfasst, wobei die Float-Zone-Vorrichtung dazu ausgebildet ist, über die Ansteuerung des verstellbaren Kondensators (1) den vorgebbaren Wert der Frequenz für den Anfangskonus, den Zylinderstababschnitt und den Endkonus unabhängig voneinander einzustellen.

5. Float-Zone-Vorrichtung nach einem der Ansprüche 1 bis 4, wobei der verstellbare Kondensator (1) dazu ausgebildet ist, die einstellbare Frequenz während des Float-Zone-Ziehprozesses im Wesentlichen auf einem konstanten Wert zu halten, der in dem Bereich von 2600 kHz bis 3100 kHz liegt, vorzugsweise in dem Bereich von 2850 kHz bis 3000 kHz liegt, vorzugsweise im Wesentlichen 2970 kHz, entspricht.

6. Float-Zone-Vorrichtung nach einem der Ansprüche 1 bis 5, wobei der verstellbare Kondensator (1), dazu ausgebildet ist, einen lastbedingten Frequenzgang, insbesondere in einem Bereich von 150 bis 200 kHz, während des Float-Zone-Prozesses zur Herstellung eines Einkristallstabs aus einem Polykristallstab, zu vermeiden.

7. Verfahren zur Herstellung eines Einkristallstabs, insbesondere aus Silizium, aus einem Polykristallstab, insbesondere aus Silizium, mittels Float-Zone-Prozess an einer Float-Zone-Vorrichtung nach einem der Ansprüche 1 bis 6, wobei
• während des Float-Zone-Prozesses aus dem Polykristallstab über sukzessives, zonenweises Aufschmelzen entlang der Höhenrichtung des Polykristallstabs durch induktive Erwärmung mittels der kontinuierlichen Einbringung thermischer Leistung über eine sich entlang der Höhenrichtung des Polykristallstabs bewegende, und den Polykristallstab beabstandet umgebende, Spuleneinheit (5) der Float-Zone-Vorrichtung, der Einkristallstab hergestellt wird, wobei eine aktuelle thermische Leistung während des Float-Zone-Prozesses aus einer aktuellen Wirkleistung einer Sendereinheit (4), umfassend einen Kondensator (1), der Float-Zone-Vorrichtung stammt, die mit der Spuleneinheit (5), insbesondere über eine Leistungsgeneratoreinheit, elektrisch zusammenwirkt, wobei
• während des Float-Zone-Prozesses der Kondensator(1), der verstellbar ausgeführt ist, die Frequenz der Sendereinheit (4) auf einem vorgebbaren und im Wesentlichen konstanten Wert über den Float-Zone-Prozess einstellbar hält.

8. Verfahren nach Anspruch 7, wobei der verstellbare Kondensator (1) mittels eines Stellantriebes über eine Regelschleife betreibbar ist, wobei die Ansteuerung der Stellung des Kondensators (1) über eine Motoreinheit (3) erfolgt.

9. Verfahren nach Anspruch 8, wobei die Motoreinheit (3) über die Ansteuerung der Stellung des Kondensators (1) den vorgebbaren Wert der Frequenz, unabhängig von der Last, über den Float-Zone-Prozess kontinuierlich einstellt.

10. Verfahren nach einem der Ansprüche 7 bis 9, wobei der Einkristallstab einen Anfangskonus, einen im Wesentlichen geformten Zylinderstababschnitt und einen Endkonus umfasst, wobei der vorgebbare Wert der Frequenz über die Ansteuerung des verstellbaren Kondensators (1) für den Anfangskonus, den Zylinderstababschnitt und den Endkonus unabhängig voneinander eingestellt wird.

11. Verfahren nach einem der Ansprüche 7 bis 10, wobei der vorgebbare Wert der Frequenz in dem Bereich von 2600 kHz bis 3100 kHz liegt, vorzugsweise in dem Bereich von 2850 kHz bis 3000 kHz liegt, vorzugsweise im Wesentlichen 2970 kHz, entspricht.

12. Verfahren zur Herstellung einer Scheibe aus Halbleitermaterial aus einem Einkristallstab, insbesondere aus einem Silizium, welcher mit dem Verfahren zur Herstellung eines Einkristallstabs, insbesondere aus Silizium, mittels Float-Zone-Prozess nach einem der Ansprüche 7 bis 11 an einer Float-Zone-Vorrichtung nach einem der Ansprüche 1 bis 6 hergestellt wurde, wobei ausgehend von dem Ende des Verfahrens zur Herstellung des Einkristallstabs wenigstens folgende Schritte folgen:
• Sägen des Einkristallstabs in dünne Scheiben,
• Chemische und/oder mechanische Weiterbehandlung wenigstens einer der dünnen Scheiben aus Halbmaterial, wobei die Weiterbehandlung wenigstens einen Weiterbehandlungsschritt aus Kantenverrunden, Läppen, Reinigen, Polieren, Abscheiden einer Oxidschicht, epitaktisches Wachsen einer einkristallinen Schicht, insbesondere Siliziumschicht, oder einer SiGe Schicht oder einer GaN Schicht, umfasst.
